# EUROPEAN PATENT APPLICATION

(11) **EP 1 691 383 A1**
(43) Date of publication of application: **16.08.2006**
(21) Application number: 06000603.8
(22) Date of filing: 12.01.2006
(51) Int. Cl.: H01G 4/10, H01L 21/31, H01G 4/06

(54) **Capacitor, method of making the same, filter using the same, and dielectric thin film used for the same**

(30) Priority: 14.02.2005 JP 2005036610; 14.02.2005 JP 2005036703
(71) Applicant: TDK Corporation, Tokyo 103-8272 (JP)
(72) Inventor: Shibata, Makoto, Tokyo 103-8272 (JP); Miyazaki, Masahiro, Tokyo 103-8272 (JP)
(74) Representative: Grünecker, Kinkeldey, Stockmair & Schwanhäusser Anwaltssozietät

(57) **Abstract**

The capacitor (10) in accordance with the present invention comprises a lower electrode (14A), a dielectric layer (16) including an SiO₂ layer (20) formed on the lower electrode (14A) and an Si₃N₄ layer (22) formed on the SiO₂ layer (20), and an upper electrode (14B) formed on the dielectric layer (16). When the SiO₂ layer (20) is thus interposed between the lower electrode (14A) and Si₃N₄ layer (22), the lower electrode (14A) and Si₃N₄ layer (22) adhere to each other more firmly than in the case where the Si₃N₄ layer (22) is directly formed on the lower electrode (14A) as in a conventional capacitor. Namely, since the dielectric layer (16) includes the Si₃N₄ layer having a higher dielectric constant, the capacitor (10) in accordance with the present invention yields a large capacitance, while the adhesion between the dielectric layer (16) and lower electrode (14A) is improved over the conventional capacitor.

## Description

### BACKGROUND OF THE INVENTION

### Field of the Invention

The present invention relates to a capacitor including a thin film dielectric layer, a method of making the same, a filter using the same, and a dielectric thin film used for the same.

### Related Background Art

A dielectric layer constituting a capacitor in this technical field has conventionally been disclosed in Japanese Patent Application Laid-Open No. HEI 11-8359, for example. This publication discloses the use of silicon nitride (Si₃N₄) in an insulating film functioning as a dielectric layer of the capacitor. Metal nitrides such as Si₃N₄ are suitable for the dielectric layer in the capacitor because of their high dielectric constant. Therefore, when the dielectric layer is constructed by such a metal nitride, the capacitor can increase its capacitance as compared with the case where the dielectric layer is constructed by a metal oxide such as SiO₂ which has conventionally been in heavy use.

However, the metal nitride layer has been known to yield a greater film stress at the time of forming the film as compared with metal oxide layers in general. Consequently, there have been cases where, when a dielectric layer is formed on a surface of a lower electrode, the dielectric layer fails to adhere to the lower electrode sufficiently, and thus peels off from the lower electrode in annealing, ultrasonic cleaning, or the like in a later stage.

For overcoming the problem mentioned above, it is an object of the present invention to provide a capacitor, a method of manufacturing the same, a filter using the same, and a dielectric thin film used for the same, which improve the adhesion between the dielectric layer and lower electrode while increasing the capacitance.

### SUMMARY OF THE INVENTION

The capacitor in accordance with the present invention comprises a lower electrode, a dielectric layer including a metal oxide layer formed on the lower electrode and a metal nitride layer formed on the metal oxide layer, and an upper electrode formed on the dielectric layer.

In this capacitor, the metal oxide layer of the dielectric layer is formed on the lower electrode. The metal nitride layer is formed on the metal oxide layer. When the metal oxide layer is thus interposed between the lower electrode and metal nitride layer, the lower electrode and the metal nitride layer adhere to each other more firmly than in the case where the metal nitride layer is directly formed on the lower electrode as in a conventional capacitor. Namely, since the dielectric layer includes the metal nitride layer having a high dielectric constant, the capacitor in accordance with the present invention yields a large capacitance, while the adhesion between the dielectric layer and lower electrode is improved over the conventional capacitor.

Preferably, a metal constituting the metal oxide layer and a metal constituting the metal nitride layer are the same. When forming the metal oxide layer and metal nitride layer by sputtering, for example, these layers can be formed by one metal target alone in this case, whereby the labor and time required for making the capacitor can be cut down.

Preferably, the metal constituting the metal oxide layer and metal nitride layer is Si or Al. In this case, the metal is easily available, and practical device characteristics can be obtained.

Preferably, the dielectric layer further comprises a metal oxynitride layer interposed between the metal oxide layer and metal nitride layer. As a result of diligent studies, the inventors have newly found the interposition of the metal oxynitride layer between the metal oxide layer and metal nitride layer as a technique for improving the adhesion between metal nitride and metal oxide layers which yield respective film stresses different from each other. When the metal oxynitride layer is thus interposed between the metal oxide layer and metal nitride layer, the metal oxide layer and metal nitride layer firmly adhere to each other, whereby the adhesion between the metal oxide layer and metal nitride layer constituting the dielectric layer improves. Namely, this capacitor further improves the adhesion between the layers constituting the dielectric layer, while increasing the capacitance and enhancing the adhesion between the dielectric layer and lower electrode.

Preferably, the oxygen content in the metal oxynitride layer gradually decreases from the metal oxide layer to the metal nitride layer. In this case, the metal oxide layer continuously changes to the metal nitride layer within the dielectric layer, whereby the adhesion between the metal oxide layer and metal nitride layer further improves.

Preferably, a metal constituting the metal oxide layer, a metal constituting the metal oxynitride layer, and a metal constituting the metal nitride layer are the same. When forming the metal oxide layer, metal oxynitride layer, and metal nitride layer by sputtering, for example, these layers can be formed by one metal target alone in this case, whereby the labor and time required for making the capacitor can be cut down.

Preferably, the metal constituting the metal oxide layer, metal oxynitride layer, and metal nitride layer is Si or Al. In this case, the metal is easily available, and practical device characteristics can be obtained.

Preferably, a constituent material of the lower electrode includes at least one species of material selected from the group consisting of Cu, Ag, Ni, W, Mo, Ti, Cr, and Al. In this case, the metal oxide layer interposed between the lower electrode and metal nitride layer makes the lower electrode firmly adhere to the metal nitride layer.

The filter in accordance with the present invention includes a capacitor comprising a lower electrode, a dielectric layer including a metal oxide layer formed on the lower electrode and a metal nitride layer formed on the metal oxide layer, and an upper electrode formed on the dielectric layer.

In this filter, the metal oxide layer of the dielectric layer is formed on the lower electrode of the capacitor. The metal nitride layer is formed on the metal oxide layer. When the metal oxide layer is thus interposed between the lower electrode and metal nitride layer, the lower electrode and the metal nitride layer adhere to each other more firmly than in the case where the metal nitride layer is directly formed on the lower electrode as in a conventional capacitor. Namely, since the dielectric layer includes the metal nitride layer having a high dielectric constant, the capacitor of the filter in accordance with the present invention yields a large capacitance while the adhesion between the dielectric layer and lower electrode is improved over the conventional capacitor.

Preferably, the dielectric layer further comprises a metal oxynitride layer interposed between the metal oxide layer and metal nitride layer. Since the metal oxide layer and metal nitride layer firmly adhere to each other, this filter further improves the adhesion between the layers constituting the dielectric layer, while increasing the capacitance and enhancing the adhesion between the dielectric layer and lower electrode.

The method of manufacturing a capacitor in accordance with the present invention comprises the steps of forming a metal oxide layer on a lower electrode and forming a metal nitride layer on the metal oxide layer, so as to form a dielectric layer including the metal oxide layer and metal nitride layer; and forming an upper electrode on the dielectric layer.

In this method of manufacturing a capacitor, a metal oxide layer of a dielectric layer is formed on a lower electrode, and a metal nitride layer is formed on the metal oxide layer. When the metal oxide layer is thus interposed between the lower electrode and metal nitride layer, the lower electrode and the metal nitride layer adhere to each other more firmly than in the case where the metal nitride layer is directly formed on the lower electrode as in a conventional capacitor. Namely, the method of manufacturing a capacitor in accordance with the present invention can yield a capacitor which has a dielectric layer including a metal nitride layer with a high dielectric constant and yields a large capacitance while the adhesion between the dielectric layer and lower electrode is improved over the conventional capacitor.

Preferably, the metal oxide layer and metal nitride layer are formed by sputtering, sputtering with a metal target is performed in a gas atmosphere containing an oxygen gas when forming the metal oxide layer by sputtering, and sputtering with the metal target used for forming the metal oxide layer by sputtering is performed in a gas atmosphere containing a nitrogen gas when forming the metal nitride layer by sputtering. In this case, the metal oxide layer and metal nitride layer are formed by one metal target alone, whereby the labor and time required for making the capacitor can be cut down.

Preferably, when forming the dielectric layer, a metal oxynitride layer is formed on the metal oxide layer prior to the metal nitride layer, so as to interpose the metal oxynitride layer between the metal oxide layer and metal nitride layer. This method of manufacturing a capacitor forms the metal oxide layer of the dielectric layer on the lower electrode, and successively forms the metal oxynitride layer and metal nitride layer on the metal oxide layer. When the metal oxynitride layer is thus interposed between the metal oxide layer and metal nitride layer, the metal oxide layer and metal nitride layer firmly adhere to each other. Namely, this method of manufacturing a capacitor can yield a capacitor which further improves the adhesion between the layers constituting the dielectric layer, while increasing the capacitance and enhancing the adhesion between the dielectric layer and lower electrode.

Preferably, the metal oxide layer, metal oxynitride layer, and metal nitride layer are formed by sputtering, sputtering with a metal target is performed in a gas atmosphere containing an oxygen gas when forming the metal oxide layer by sputtering, and sputtering with the metal target used for forming the metal oxide layer by sputtering is performed in a gas atmosphere containing a nitrogen gas and an oxygen gas and in a gas atmosphere containing a nitrogen gas when forming the metal oxynitride layer and metal nitride layer by sputtering, respectively. In this case, the metal oxide layer, metal oxynitride layer, and metal nitride layer are formed by one metal target alone, whereby the labor and time required for making the capacitor can be cut down.

The dielectric thin film in accordance with the present invention is a dielectric thin film used for a capacitor, the dielectric thin film including a metal oxynitride layer whose oxygen content gradually changes along a thickness direction.

This dielectric thin film includes a metal oxynitride layer, whose oxygen content gradually changes along its thickness direction. Consequently, the metal oxynitride layer is in a state where a region having a relatively low oxygen content and a region having a relatively high oxygen content are substantially continuously connected to each other. Therefore, using this dielectric thin film for a capacitor realizes a high dielectric constant in the region having a low oxygen content, and a high adhesion to the lower electrode in the region having a high oxygen content.

Preferably, the dielectric thin film further comprises a metal oxide layer and a metal nitride layer, the metal oxynitride layer is interposed between the metal oxide layer and metal nitride layer, and the oxygen content of the metal oxynitride layer gradually decreases from the metal oxide layer to the metal nitride layer. In this case, the metal oxynitride layer makes the metal oxide layer and metal nitride layer firmly adhere to each other.

### BRIEF DESCRIPTION OF THE DRAWINGS

Fig. 1 is a schematic sectional view showing the capacitor in accordance with a first embodiment of the present invention;

Fig. 2 is a partly broken perspective view showing a sputtering apparatus used for making the capacitor shown in Fig. 1;

Fig. 3 is a view showing a procedure of making the capacitor shown in Fig. 1;

Fig. 4 is a schematic sectional view showing the capacitor in accordance with a second embodiment of the present invention;

Fig. 5 is a view showing a procedure of making the capacitor shown in Fig. 4;

Fig. 6 is a time chart showing changes in oxygen and nitrogen gases introduced into the sputtering apparatus shown in Fig. 2 when forming the dielectric layer in the capacitor shown in Fig. 4;

Fig. 7 is a schematic view showing the dielectric thin film in accordance with the second embodiment of the present invention; and

Fig. 8 is a diagram showing examples of filters in which the capacitors shown in Figs. 1 and 4 are employed.

### DESCRIPTION OF THE PREFERRED EMBODIMENTS

In the following, modes considered to be the best when carrying out the capacitor, the method of manufacturing the same, the filter using the same, and the dielectric thin film used for the same will be explained in detail with reference to the accompanying drawings. Constituents identical or equivalent to each other will be referred to with numerals identical to each other without repeating their overlapping explanations if any.

### First Embodiment

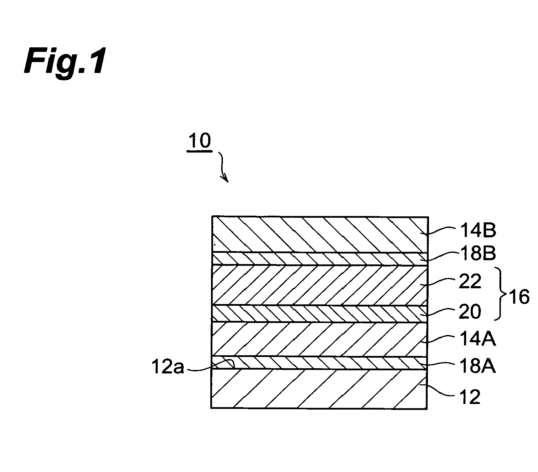

Fig. 1 is a schematic sectional view showing the capacitor in accordance with a first embodiment of the present invention. This capacitor 10 has a thin film laminate structure comprising a substrate 12, a pair of electrodes 14A, 14B for applying a voltage to the capacitor 10, and a dielectric layer 16 interposed between the pair of electrodes 14A, 14B.

The substrate 12 is constituted by Al₂O₃, whereas its surface may be coated with an Al₂O₃ thin film in order to improve its flatness as appropriate. The constituent material of the substrate 12 can be changed to Si, for example.

In the pair of electrodes 14A, 14B, the electrode (hereinafter referred to as lower electrode) 14A closer to the substrate 12 is formed by plating on a Cu seed layer 18A formed by sputtering on the surface 12a of the substrate 12, and is constituted by Cu.

An SiO₂ layer 20 (with a thickness of 10 nm) and an Si₃N₄ layer 22 (with a thickness of 100 nm) which constitute the dielectric layer 16 are successively laminated on the lower electrode 14A. The SiO₂ layer 20 is constituted by amorphous SiO₂, whereas the Si₃N₄ layer 22 is constituted by amorphous Si₃N₄. The thickness (D1) of the SiO₂ layer 20 is not limited to 10 nm but may be changed within the range of 5 nm ≤D1 ≤ 15 nm as appropriate. The insulation by the SiO₂ layer 20 is harder to achieve reliably when the thickness D1 of the SiO₂ layer 20 is smaller than 5 nm, whereas a capacitor characteristic at a practical level may not be obtained when the thickness D1 is greater than 15 nm. The thickness (D2) of the Si₃N₄ layer 22 may also be changed as appropriate without being restricted to 100 nm.

In the pair of electrodes 14A, 14B, the electrode (hereinafter referred to as upper electrode) 14B remote from the substrate 12 is formed on the dielectric layer 16. The upper electrode 14B is formed by plating as with the lower electrode 14A, and is constituted by Au. The upper electrode 14B is formed by plating on an Au seed layer 18B formed by sputtering on the dielectric layer 16, and is constituted by Au.

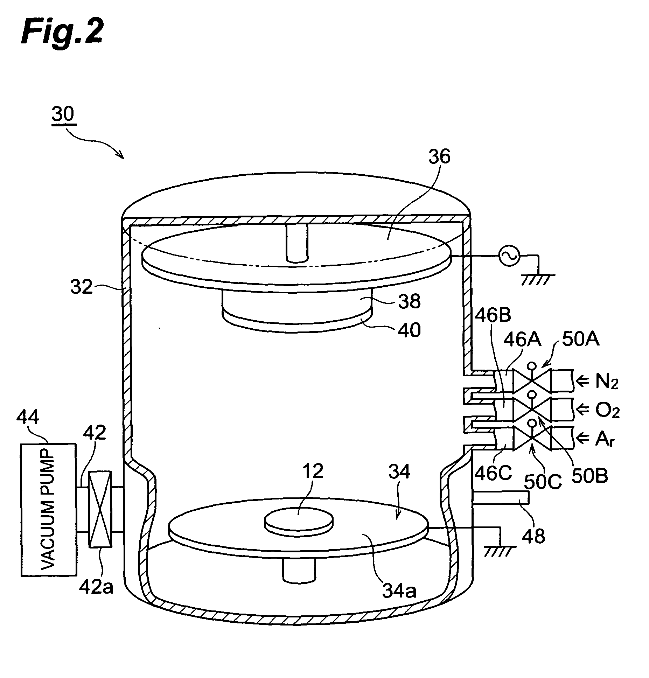

A sputtering apparatus used when making the capacitor 10 will now be explained with reference to Fig. 2. Fig. 2 is a partly broken perspective view showing the sputtering apparatus in accordance with the first embodiment of the present invention. This sputtering apparatus 30 is a film-forming apparatus of high-frequency sputtering type.

The sputtering apparatus 30 comprises a chamber 32, a substrate holder 34 disposed near a lower end part within the chamber 32, and a target support plate 36 disposed near an upper end part within the chamber 32.

A target holder 38 is fixed to the target support plate 36, whereas a metal target 40 is attached to the target holder 38. Si is used for the metal target 40. An unshown shutter is provided so as to face the metal target 40, and is opened/closed as necessary.

The substrate holder 34 is formed like a disk, and has an upper face 34a on which the substrate 12 formed with the lower electrode 14A is mounted. The substrate 12 faces the target support plate 36, so that the dielectric layer 16 is formed on the lower electrode 14A of the substrate 12 when sputtering with the metal target 40 attached to the target support plate 36 is performed.

By way of a pipe 42, a vacuum pump 44 is attached to the chamber 32. The chamber 32 can attain a vacuum state therewithin as a valve 42a in the pipe 42 is opened/closed. Three gas ducts 46A, 46B, 46C for introducing atmosphere gases into the chamber 32 and an exhaust duct 48 used for exhaust are attached to the chamber 32.

A nitrogen gas, an oxygen gas, and an argon gas are introduced from their corresponding gas ducts 46A, 46B, 46C, and their flow rates are controlled by valves (e.g., electromagnetic valves) 50A, 50B, 50C disposed therewithin.

In a state where the atmosphere within the chamber is adjusted by selectively introducing predetermined gases from the three gas ducts 46A, 46B, 46C, a high-frequency voltage is applied between the target support plate 36 and substrate holder 34, so as to begin sputtering with the metal target 40. More specifically, an SiO₂ layer is formed on the substrate 12 when sputtering is performed while introducing the oxygen gas and argon gas into the chamber 32, whereas an Si₃N₄ layer is formed on the substrate 12 when sputtering is performed while introducing the nitrogen gas and argon gas into the chamber 32. Thus, both of the SiO₂ and Si₃N₄ layers can be formed by changing only the atmosphere gas within the chamber 32 without changing the metal target 40 (i.e., by using only one metal target), whereby the above-mentioned dielectric layer 16 can easily be formed by using this sputtering apparatus 30.

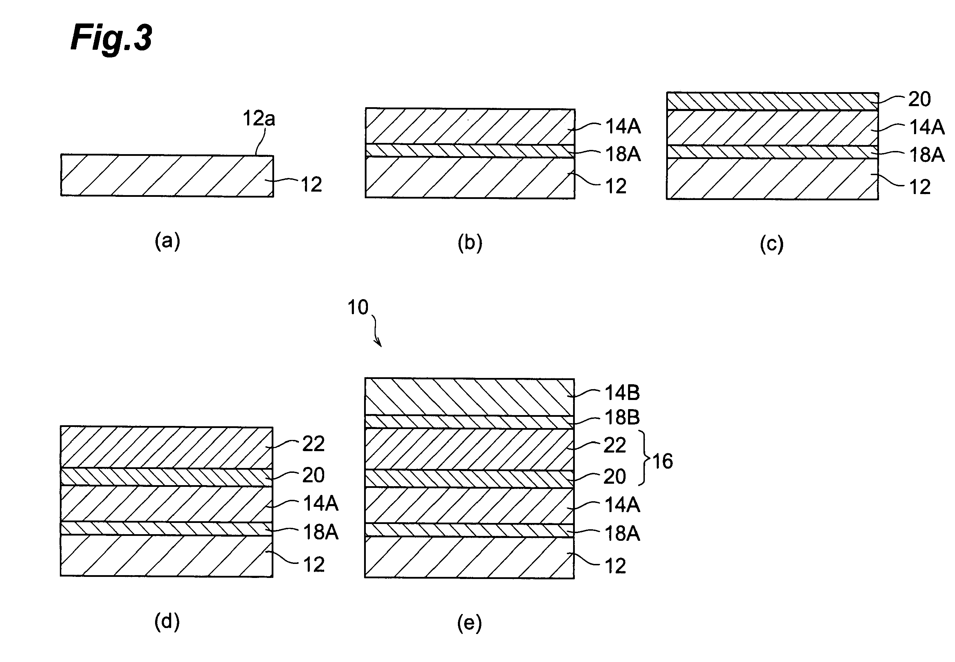

A procedure of making the above-mentioned capacitor 10 will now be explained with reference to Fig. 3. Fig. 3 is a view successively showing the procedure of making the capacitor 10.

When making the capacitor 10, the substrate 12 shown in part (a) of Fig. 3 is initially prepared, the Cu seed layer 18A is formed by sputtering on the upper face 12a of the substrate 12, and Cu is formed by plating on the Cu seed layer 18A, so as to form the lower electrode 14A (see part (b) of Fig. 3). The lower electrode 14A may be subjected to chemical mechanical polishing (CMP) as necessary.

Next, the substrate 12 formed with the lower electrode 14A is mounted on the substrate holder 34 of the above-mentioned sputtering apparatus 30, the chamber 32 is caused to attain therewithin a mixed gas atmosphere constituted by the oxygen gas and argon gas introduced from the gas ducts 46B, 46C, and then sputtering with the metal target 40 is performed, so as to form the SiO₂ layer 20 on the upper face of the lower electrode 14A (see part (c) of Fig. 3). After forming the SiO₂ layer 20, the mixed gas is discharged by way of the exhaust duct 48, the chamber 32 is caused to attain therewithin a mixed gas atmosphere constituted by the nitrogen gas and argon gas introduced from the gas ducts 46A, 46C, and then sputtering with the metal target 40 is performed, so as to form the Si₃N₄ layer 22 on the upper face of the SiO₂ layer 20 (see part (d) of Fig. 3).

After forming the dielectric layer 16 constituted by the SiO₂ layer 20 and Si₃N₄ layer 22 as in the foregoing, the substrate 12 is taken out of the sputtering apparatus 30, the Au seed layer 18B is formed by sputtering on the upper face of the Si₃N₄ layer 22, and the upper electrode 14B is formed by plating on the Au seed layer 18B, whereby the making of the capacitor 10 is completed (see part (e) of Fig. 3).

As explained in the foregoing, a part of the dielectric layer 16 in the capacitor 10 is constituted by the Si₃N₄ layer 22. In general, metal nitride layers such as the Si₃N₄ layer 22 have been known to make the capacitance of the capacitor greater than metal oxide layers such as the SiO₂ layer 20 do. Therefore, this dielectric layer 16 has a capacitance greater than that of the dielectric layer constituted by the metal oxide layer alone.

The inventors have newly found that, when the Si₃N₄ layer 22 exhibiting a greater film stress is formed onto the lower electrode 14A, the interposition of the SiO₂ layer 20, which is a metal oxide layer yielding a lower film stress, between the Si₃N₄ layer 22 and the lower electrode 14A improves the adhesion between the Si₃N₄ layer 22 and the lower electrode 14A higher than that in the case the Si₃N₄ layer 22 is directly formed on the lower electrode 14A. Namely, forming the SiO₂ layer 20 constituting a part of the dielectric layer 16 onto the lower electrode 14A before forming the Si₃N₄ layer 22 of the dielectric layer 16 makes the dielectric layer 16 and lower electrode 14A adhere to each other firmly. Therefore, the capacitor 10 significantly restrains the dielectric layer 16 from peeling off from the lower electrode 14A in annealing, ultrasonic cleaning, or the like performed in a later stage.

The same metal, i.e., Si, constitutes the SiO₂ layer 20 and Si₃N₄ layer 22 in the dielectric layer 16. When forming the SiO₂ layer 20 and Si₃N₄ layer 22 by sputtering while using the above-mentioned sputtering apparatus 30, these layers can be formed by one metal target 40 alone. Namely, the SiO₂ layer 20 is formed by sputtering with the metal target 40 in the mixed gas atmosphere of the oxygen gas and argon gas, whereas the Si₃N₄ layer 22 is formed by sputtering with the metal target 40, which is used for forming the SiO₂ layer 20 by sputtering, in the mixed gas atmosphere of the nitrogen gas and argon gas. Therefore, it is not necessary for the metal target to change each time when forming the films 20, 22, whereby the labor and time required for making the capacitor 10 can be reduced. The metal target 40 may not only be Si but Al, since the latter is easily available and can yield a practical device characteristic. Using Al as the metal target 40 yields a capacitor in which an Al₂O₃ layer and an AIN layer are formed in place of the SiO₂ layer 20 and Si₃N₄ layer 22, respectively.

Here, though the adhesion between the lower electrode 14A and Si₃N₄ layer 22 is likely to decrease since the lower electrode 14A is constituted by Cu which is easier to oxidize, the interposition of the SiO₂ layer 20 between the lower electrode 14A and Si₃N₄ layer 22 effectively improves the adhesion between the dielectric layer 16 and lower electrode 14A. In other words, the SiO₂ layer 20 interposed between the lower electrode 14A and Si₃N₄ layer 22 makes the lower electrode 14A firmly adhere to the Si₃N₄ layer 22. The lower electrode 14A may contain at least one constituent material selected from the group consisting of Cu, Ag, Ni, W, Mo, Ti, Cr, and Al as long as they are materials easier to oxidize as with Cu.

### Second Embodiment

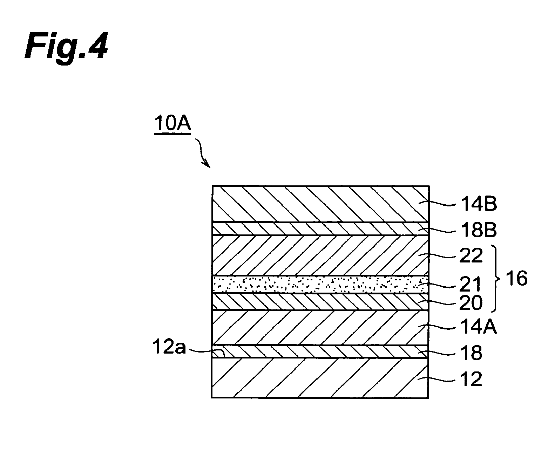

Fig. 4 is a schematic sectional view showing the capacitor in accordance with a second embodiment of the present invention. This capacitor 10A has a thin film laminate structure comprising a substrate 12, a pair of electrodes 14A, 14B for applying a voltage to the capacitor 10A, and a dielectric layer 16 interposed between the pair of electrodes 14A, 14B as with the capacitor 10 in accordance with the first embodiment.

The dielectric layer 16 in the capacitor 10A is constructed by successively laminating an SiO₂ layer 20 (with a thickness of 7.5 nm), an SiON layer 21 (with a thickness of 7.5 nm), and an Si₃N₄ layer 22 (with a thickness of 150 nm) on the lower electrode 14A. Here, the SiON layer 21 is constituted by amorphous SiON (oxynitride of Si), whereas its oxygen content gradually decreases from the SiO₂ layer 20 to the Si₃N₄ layer 22 (i.e., toward the upper side of Fig. 4). The thickness (D3) of the SiO₂ layer 20 may be changed as appropriate within the range of 3 nm ≤ D3 ≤ 15 nm. The insulation by the SiO₂ layer 20 is harder to achieve reliably when the thickness D3 of the SiO₂ layer 20 is smaller than 3 nm, whereas a capacitor characteristic at a practical level may not be obtained when the thickness D3 is greater than 15 nm. The thickness (D4) of the SiON layer 21 may be changed as appropriate within the range of 3 nm ≤ D4 ≤ 15 nm. A gradient in the oxygen content is harder to attain when the thickness D4 of the Si₃N₄ layer 22 is smaller than 3 nm, whereas a capacitor characteristic at a practical level may not be obtained when the thickness D4 is greater than 15 nm. The thickness (D5) of the Si₃N₄ layer 22 may also be changed as appropriate without being restricted to 150 nm.

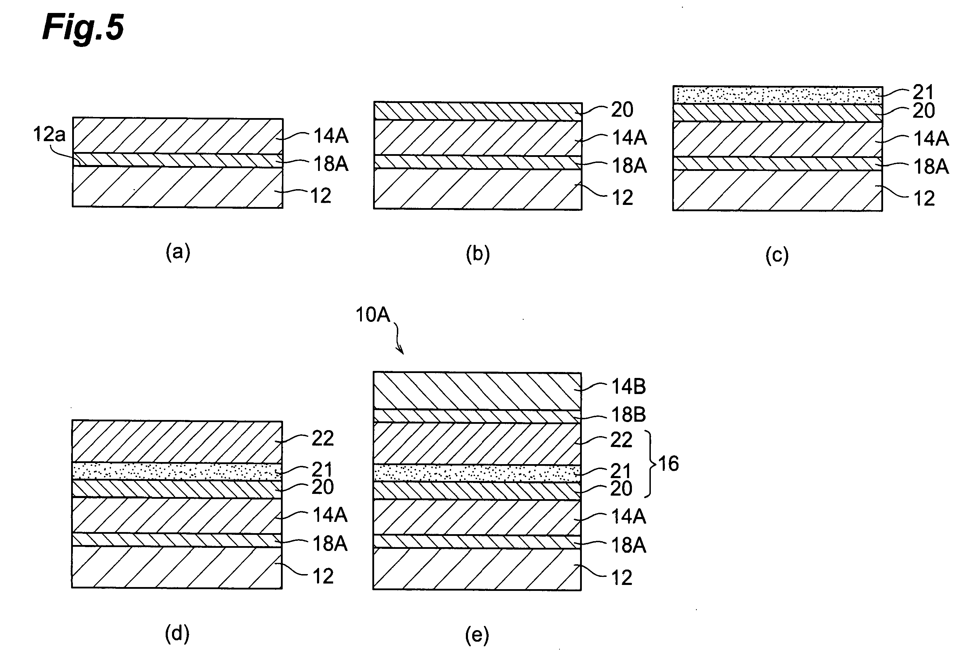

A procedure of making the above-mentioned capacitor 10A will now be explained with reference to Fig. 5. Fig. 5 is a view successively showing the procedure of making the capacitor 10A.

When making the capacitor 10A, as in the procedure of making the capacitor 10, the substrate 12 is initially prepared, the Cu seed layer 18A is formed by sputtering on the upper face 12a of the substrate 12, and Cu is formed by plating on the Cu seed layer 18A, so as to form the lower electrode 14A (see part (a) of Fig. 5). The lower electrode 14A may be subjected to chemical mechanical polishing as necessary.

Next, the substrate 12 formed with the lower electrode 14A is mounted on the substrate holder 34 of the sputtering apparatus 30 shown in the first embodiment, the chamber 32 is caused to attain therewithin a mixed gas atmosphere constituted by the oxygen gas and argon gas introduced from the gas ducts 46B, 46C, and then sputtering with the metal target 40 is performed, so as to form the SiO₂ layer 20 on the upper face of the lower electrode 14A (see part (b) of Fig. 5). After forming the SiO₂ layer 20, the valves 50A, 50B of the gas ducts 46A, 46B are regulated so as to gradually decrease the flow rate of oxygen gas introduced from the gas duct 46B and gradually increase the flow rate of nitrogen gas introduced from the gas duct 46A, and sputtering with the metal target 40 is performed, so as to form the SiON layer 21 on the upper face of the SiO₂ layer 20 (see part (c) of Fig. 5). The sputtering with the metal target 40 is continued until the flow rate of oxygen gas introduced from the gas duct 46B decreases such that the chamber 32 attains therewithin a mixed gas atmosphere constituted by only the nitrogen gas and argon gas, so as to form the Si₃N₄ layer 22 on the upper face of the SiON layer 21 (see part (d) of Fig. 5). Thus, the dielectric layer 16 constituted by the SiO₂ layer 20, SiON layer 21, and Si₃N₄ layer 22 is formed.

Namely, the SiO₂ layer is formed on the substrate 12 when sputtering is performed while introducing the oxygen gas and argon gas into the chamber 32, whereas the Si₃N₄ layer is formed on the substrate 12 when sputtering is performed while introducing the nitrogen gas and argon gas into the chamber 32. The SiON layer is formed on the substrate 12 when sputtering is performed while introducing the oxygen gas, nitrogen gas, and argon gas into the chamber 32. Thus, all of the SiO₂ layer, SiON layer, and Si₃N₄ layer can be formed by changing only the atmosphere gas within the chamber 32 without changing the metal target 40 (i.e., by using only one metal target), whereby the above-mentioned dielectric layer 16 can easily be formed by using this sputtering apparatus 30.

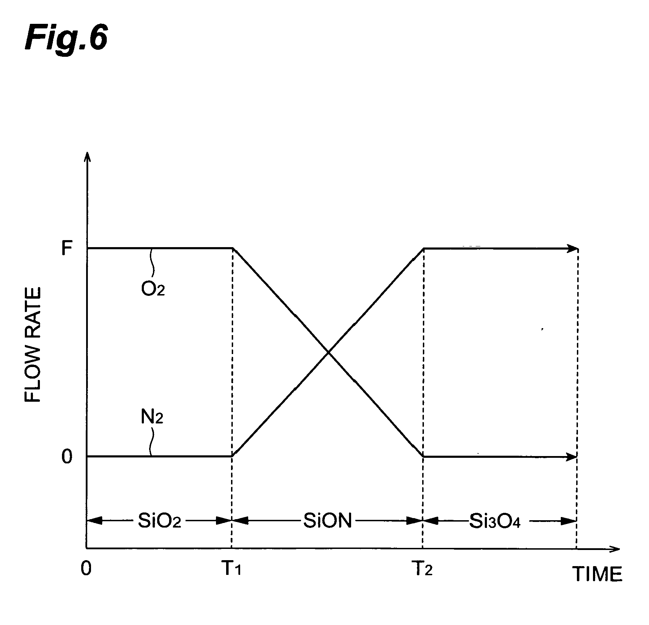

The mixed gas introduced into the chamber 32 when forming the dielectric layer 16 will now be explained in more detail with reference to Fig. 6. Fig. 6 is a time chart showing changes in oxygen and nitrogen gases introduced into the chamber 32 when forming the dielectric layer 16. Namely, during the time of forming the SiO₂ layer 20 (the time up to T₁ in Fig. 6), a predetermined flow rate F of oxygen gas is introduced into the chamber 32 while no nitrogen gas is introduced. During the time of forming the SiON layer 21 (T₁ to T₂) after completing the forming of the SiO₂ layer 20, the flow rates of oxygen gas and nitrogen gas introduced into the chamber 32 gradually decrease and increase, respectively. Therefore, the oxygen content of the SiON layer 21 gradually decreases. During the time of forming the Si₃N₄ layer 22 after completing the forming of the SiON layer 21 (the time after T₂), the predetermined flow rate F of nitrogen gas is introduced while no oxygen gas is introduced. Though not shown in the time chart of Fig. 6, a predetermined flow rate of argon gas is introduced into the chamber 32 as needed.

After forming the dielectric layer 16, the substrate 12 is taken out of the sputtering apparatus 30, the Au seed layer 18B is formed by sputtering on the upper face of the Si₃N₄ layer 22, and the upper electrode 14B is formed by plating on the Au seed layer 18B, whereby the making of the capacitor 10A is completed (see part (e) of Fig. 5).

As explained in the foregoing, a part of the dielectric layer 16 in the capacitor 10A is constituted by the Si₃N₄ layer 22. In general, metal nitride layers such as the Si₃N₄ layer 22 have been known to make the capacitance of the capacitor greater than metal oxide layers such as the SiO₂ layer 20 do. Therefore, this dielectric layer 16 has a capacitance greater than that of the dielectric layer constituted by the metal oxide layer alone.

Further, forming the SiO₂ layer 20 constituting a part of the dielectric layer 16 onto the lower electrode 14A before forming the Si₃N₄ layer 22 makes the dielectric layer 16 and lower electrode 14A adhere to each other firmly in the capacitor 10A as in the capacitor 10. Therefore, the capacitor 10A significantly restrains the dielectric layer 16 from peeling off from the lower electrode 14A in annealing, ultrasonic cleaning, or the like performed after forming the dielectric layer 16.

Furthermore, between the SiO₂ layer 20 yielding a lower film stress and the Si₃N₄ layer 22 yielding a higher film stress, an SiON layer 21 which is a metal oxynitride layer yielding an intermediate film stress is interposed, so as to significantly alleviate the gap between the film stresses of the films neighboring each other, whereby the SiO₂ layer 20 and Si₃N₄ layer 22 adhere to each other firmly. In particular, since the oxygen content of the SiON layer 21 gradually decreases from the SiO₂ layer 20 to the Si₃N₄ layer 22, the SiO₂ layer 20 continuously changes to the Si₃N₄ layer 22 within the dielectric layer 16. This eliminates interfaces where the film stress changes in the dielectric layer 16, whereby the adhesion between the SiO₂ layer 20 and Si₃N₄ layer 22 further improves.

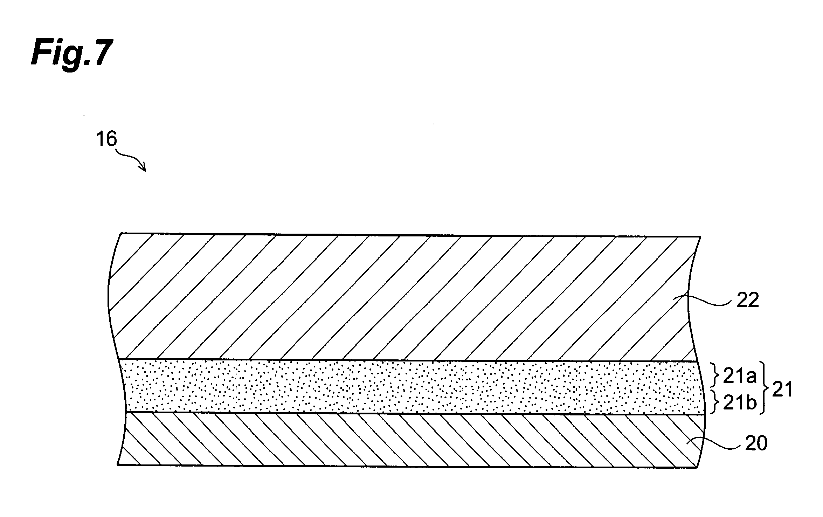

Namely, the dielectric layer (dielectric thin film) 16 of the capacitor 10A includes the SiON layer 21 whose oxygen content gradually changes along the thickness direction as shown in Fig. 7. This SiON layer 21 is in a state where a region (metal nitride region) 21a whose oxygen content is relatively low and a region (metal oxide region) 21b whose oxygen content is relatively high are continuously combined together with a high adhesion force. A high dielectric constant is realized in the metal nitride region, whereas a high adhesion to the lower electrode 14A is realized in the metal oxide region.

The dielectric layer 16 further includes the SiO₂ layer 20 and the Si₃N₄ layer 22. The SiON layer 21 is interposed between the SiO₂ layer 20 and Si₃N₄ layer 22, whereas the oxygen content of the SiON layer 21 gradually decreases from the SiO₂ layer 20 to the Si₃N₄ layer 22. Namely, the Si₃N₄ layer 22 and SiO₂ layer 20 are positioned on the metal nitride region 21a side and the metal oxide region 21b side of the SiON layer 21, respectively. Therefore, the SiON layer 21 alleviates the gap in film stress between the Si₃N₄ layer 22 and SiO₂ layer 20, whereby a high adhesion is realized.

The same metal, i.e., Si, constitutes the SiO₂ layer 20, SiON layer 21, and Si₃N₄ layer 22 in the dielectric layer 16. When forming the SiO₂ layer 20, SiON layer 21, and Si₃N₄ layer 22 by sputtering while using the above-mentioned sputtering apparatus 30, these layers can be formed by one metal target 40 alone. Namely, the SiO₂ layer 20 is formed by sputtering with the metal target 40 in the mixed gas atmosphere of the oxygen gas and argon gas, whereas the SiON layer 21 and the Si₃N₄ layer 22 are formed by sputtering with the metal target 40, which is used for forming the SiO₂ layer 20 by sputtering, in the mixed gas atmosphere of the oxygen gas, nitrogen gas, and argon gas and in the mixed gas atmosphere of the nitrogen gas and argon gas, respectively. Therefore, it is not necessary for the metal target to change each time when forming the films 20, 21, 22, whereby the labor and time required for making the capacitor 10A can be reduced. The metal target 40 may not only be Si but Al, since the latter is easily available and can yield a practical device characteristic. Using Al as the metal target 40 yields a capacitor in which an Al₂O₃ layer, an AlON layer, and an AlN layer are formed in place of the SiO₂ layer 20, SiON layer 21, and Si₃N₄ layer 22, respectively.

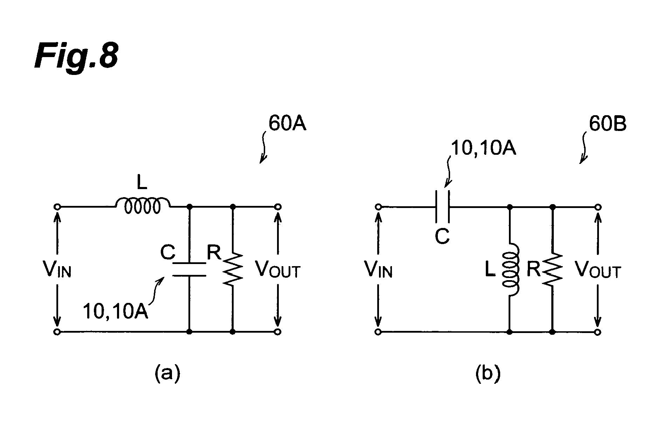

The capacitors 10, 10A explained in the foregoing can be employed in various filters such as those shown in Fig. 8, for example. Fig. 8 is a diagram showing examples of filters in which the capacitors 10, 10A are employed, in which parts (a) and (b) show a low-pass filter and a high-pass filter, respectively. Namely, each of the low-pass filter 60A shown in part (a) of Fig. 8 and the high-pass filter 60B shown in part (b) of Fig. 8 comprises one each of inductor (L), capacitor (C), and resistor (R), whereas the above-mentioned capacitors 10, 10A are used as this capacitor. Namely, the filters 60A, 60B attain a large capacitance by employing the capacitors 10, 10A, whereas the dielectric layer 16 and the lower electrode 14A firmly adhere to each other in the capacitors 10, 10A. Further, in the capacitor 10A, the SiO₂ layer 20 and Si₃N₄ layer 22 constituting the dielectric layer 16 firmly adhere to each other. Though Fig. 8 shows filters having a simple configuration, the capacitors 10, 10A can be employed in various types of filters comprising one each or a plurality of L, C, and R.

Without being restricted to the above-mentioned embodiments, the present invention can be modified in various manners. For example, the substrate is not always necessary for the capacitor and can be removed as appropriate. The sputtering apparatus used for forming the dielectric layer is not limited to those of high-frequency sputtering type, whereby sputtering apparatus of known types such as ECR sputtering types can be used.

## Claims

1. A capacitor comprising:
a lower electrode;
a dielectric layer including a metal oxide layer formed on the lower electrode and a metal nitride layer formed on the metal oxide layer; and
an upper electrode formed on the dielectric layer.

2. A capacitor according to claim 1, wherein a metal constituting the metal oxide layer and a metal constituting the metal nitride layer are the same.

3. A capacitor according to claim 2, wherein the metal constituting the metal oxide layer and metal nitride layer is Si or Al.

4. A capacitor according to claim 1, wherein the dielectric layer further comprises a metal oxynitride layer interposed between the metal oxide layer and metal nitride layer.

5. A capacitor according to claim 4, wherein the oxygen content in the metal oxynitride layer gradually decreases from the metal oxide layer to the metal nitride layer.

6. A capacitor according to claim 4 or 5, wherein a metal constituting the metal oxide layer, a metal constituting the metal oxynitride layer, and a metal constituting the metal nitride layer are the same.

7. A capacitor according to claim 6, wherein the metal constituting the metal oxide layer, metal oxynitride layer, and metal nitride layer is Si or Al.

8. A capacitor according to one of claims 1 to 7, wherein a constituent material of the lower electrode includes at least one species of material selected from the group consisting of Cu, Ag, Ni, W, Mo, Ti, Cr, and Al.

9. A filter including a capacitor comprising a lower electrode, a dielectric layer including a metal oxide layer formed on the lower electrode and a metal nitride layer formed on the metal oxide layer, and an upper electrode formed on the dielectric layer.

10. A filter according to claim 9, wherein the dielectric layer further comprises a metal oxynitride layer interposed between the metal oxide layer and metal nitride layer.

11. A method of manufacturing a capacitor, the method comprising the steps of:
forming a metal oxide layer on a lower electrode and forming a metal nitride layer on the metal oxide layer, so as to form a dielectric layer including the metal oxide layer and metal nitride layer; and
forming an upper electrode on the dielectric layer.

12. A method of manufacturing a capacitor according to claim 11, wherein the metal oxide layer and metal nitride layer are formed by sputtering;
wherein sputtering with a metal target is performed in a gas atmosphere containing an oxygen gas when forming the metal oxide layer by sputtering; and
wherein sputtering with the metal target used for forming the metal oxide layer by sputtering is performed in a gas atmosphere containing a nitrogen gas when forming the metal nitride layer by sputtering.

13. A method of manufacturing a capacitor according to claim 11, wherein, when forming the dielectric layer, a metal oxynitride layer is formed on the metal oxide layer prior to the metal nitride layer, so as to interpose the metal oxynitride layer between the metal oxide layer and metal nitride layer.

14. A method of manufacturing a capacitor according to claim 13, wherein the metal oxide layer, metal oxynitride layer, and metal nitride layer are formed by sputtering;
wherein sputtering with a metal target is performed in a gas atmosphere containing an oxygen gas when forming the metal oxide layer by sputtering; and
wherein sputtering with the metal target used for forming the metal oxide layer by sputtering is performed in a gas atmosphere containing a nitrogen gas and an oxygen gas and in a gas atmosphere containing a nitrogen gas when forming the metal oxynitride layer and metal nitride layer by sputtering, respectively.

15. A dielectric thin film used for a capacitor, the dielectric thin film including a metal oxynitride layer whose oxygen content gradually changes along a thickness direction.

16. A dielectric thin film according to claim 15, further comprising a metal oxide layer and a metal nitride layer;
wherein the metal oxynitride layer is interposed between the metal oxide layer and metal nitride layer, while the oxygen content of the metal oxynitride layer gradually decreases from the metal oxide layer to the metal nitride layer.
